(19) **Europäisches Patentamt / European Patent Office / Office européen des brevets**

(11) **EP 3 985 745 B1**

(12) **FASCICULE DE BREVET EUROPEEN**

(45) Date de publication et mention de la délivrance du brevet:
**12.07.2023 Bulletin 2023/28**

(21) Numéro de dépôt: **21198286.3**

(22) Date de dépôt: **22.09.2021**

(51) Classification Internationale des Brevets (IPC):
**H10N 10/01** *(2023.01)*    **H10N 10/17** *(2023.01)*
**H10N 10/81** *(2023.01)*

(52) Classification Coopérative des Brevets (CPC):
**H10N 10/81; H10N 10/01; H10N 10/17**

(54) **PROCÉDÉ DE FABRICATION DE DISPOSITIF THERMOÉLECTRIQUE PAR FABRICATION ADDITIVE DE PEIGNES À CONTACTER ENTRE EUX**

VERFAHREN ZUR HERSTELLUNG EINER THERMOELEKTRISCHEN VORRICHTUNG DURCH ADDITIVE FERTIGUNG VON KÄMMEN, DIE SICH GEGENSEITIG BERÜHREN

METHOD FOR MANUFACTURING A THERMOELECTRIC DEVICE BY ADDITIVE MANUFACTURING OF COMBS TO COME INTO CONTACT WITH ONE ANOTHER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **29.09.2020 FR 2009910**

(43) Date de publication de la demande:
**20.04.2022 Bulletin 2022/16**

(73) Titulaire: **Commissariat à l'Energie Atomique et aux Energies Alternatives
75015 Paris (FR)**

(72) Inventeurs:
• SAVELLI, Guillaume
**38054 Grenoble cedex 9 (FR)**
• NAVONE, Christelle
**38054 Grenoble cedex 09 (FR)**

(74) Mandataire: **Germain Maureau
12, rue Boileau
69006 Lyon (FR)**

(56) Documents cités:
**EP-A1- 0 930 658     JP-A- H 118 416
US-A1- 2019 131 508**

EP 3 985 745 B1

**Description**

**Domaine technique de l'invention**

La présente invention concerne un procédé de fabrication d'un dispositif thermoélectrique, lequel dispositif thermoélectrique comprend une pluralité de jonctions thermoélectriques où chaque jonction thermoélectrique d'une part est agencée entre un premier côté thermique et un deuxième côté thermique du dispositif thermoélectrique et d'autre part comprend un premier élément dopé selon un premier type de dopage s'étendant entre lesdits premier et deuxième côtés thermiques et un second élément dopé selon un deuxième type de dopage et s'étendant entre lesdits premier et deuxième côtés thermiques, le premier élément et le deuxième élément étant reliés électriquement entre eux au niveau de l'un desdits premier et deuxième côtés thermiques et permettant de générer un effet thermoélectrique.

L'invention permet de fabriquer un dispositif thermoélectrique où chaque jonction thermoélectrique du dispositif thermoélectrique est configurée pour générer un effet thermoélectrique, notamment lors du fonctionnement du dispositif thermoélectrique. En mode Seebeck, l'effet thermoélectrique est tel que l'au moins une jonction thermoélectrique permet la génération d'une énergie électrique lorsqu'elle est soumise à une différence de température appliquée au dispositif thermoélectrique entre son premier côté thermique et son deuxième côté thermique. En mode Peltier, l'effet thermoélectrique est tel que l'au moins une jonction thermoélectrique permet la génération d'une énergie thermique (différence de température entre les premier et deuxième côtés thermiques) lorsqu'elle est soumise à une énergie électrique alimentant électriquement ladite au moins une jonction thermoélectrique.

**Etat de la technique**

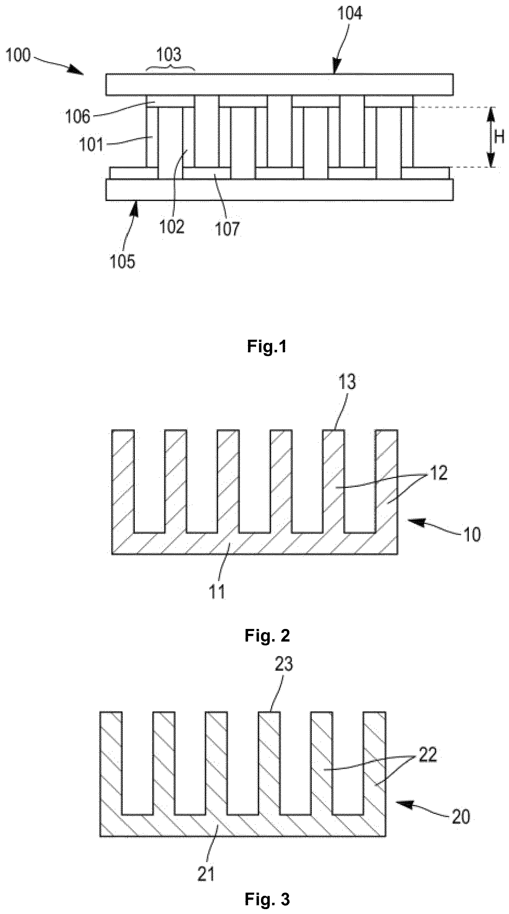

De manière connue, et comme illustre en figure 1, un dispositif thermoélectrique 100 peut comporter un ensemble de premiers plots 101 en matériau thermoélectrique et un ensemble de seconds plots 102 en matériau thermoélectrique différent du matériau thermoélectrique des premiers plots 101. Les premiers et seconds plots 101, 102 sont reliés électriquement pour former des jonctions thermoélectriques 103 entre un premier un côté 104, par exemple dit côté chaud, du dispositif thermoélectrique 100 et un deuxième côté 105, par exemple dit côté froid, du dispositif thermoélectrique 100. Chaque jonction thermoélectrique 103 comporte l'un des premiers plots 101 et l'un des seconds plots 102. Pour chaque jonction thermoélectrique 103, un élément de liaison électrique 106 permet de lier électriquement le premier plot 101 et le second plot 102 de la jonction thermoélectrique 103 correspondante, aussi appelée jonction NP dans le domaine. Des éléments de connexion 107 permettent de lier électriquement en série et/ou en parallèle les jonctions thermoélectriques 103 entre elles. Le dispositif thermoélectrique 100 de la figure 1 est composé de plusieurs premiers et seconds plots 101, 102 reliés électriquement en série et thermiquement en parallèle pour former quatre jonctions thermoélectriques 103. Notamment, dans le domaine, les premiers et seconds plots 101, 102 sont aussi respectivement appelés plots N et plots P, un plot N étant un plot à conductivité de type N (c'est-à-dire que le matériau qui le compose est à coefficient Seebeck strictement négatif) et un plot P étant un plot à conductivité de type P (c'est-à-dire que le matériau qui le compose est à coefficient Seebeck strictement positif).

De manière générale, en considérant que les dimensions (notamment la hauteur et la section) des premiers et seconds plots sont identiques, les performances électriques du dispositif thermoélectrique 100 utilisé en tant que générateur d'énergie, notamment d'énergie électrique, peuvent être données de manière simplifiée par :

- une résistance électrique interne notée Rint par exemple déterminée de la manière suivante (notée équation (1) par la suite) :

$$\text{Rint} = N \times \rho np \times H / A$$

avec N le nombre de jonctions thermoélectriques du dispositif thermoélectrique, H la hauteur d'un des premiers plots 101 d'une des jonctions thermoélectriques du dispositif thermoélectrique 100, cette hauteur H étant mesurée selon un axe orthogonal au premier côté 104 et au deuxième côté 105, A l'aire de la section dudit premier plot 101 prise orthogonalement à la direction dans laquelle est mesurée H, et $\rho np$ correspondant à la résistivité électrique dudit premier plot 101 (cette résistivité électrique étant considérée comme identique pour chaque premier plot 101 et chaque second plot 102) ;

- une tension de sortie notée V pouvant être déterminée de la manière suivante (notée équation (2) par la suite) :

$$V = N \times Snp \times \Delta T$$

avec Snp le coefficient Seebeck associé à l'une des jonctions thermoélectriques du dispositif thermoélectrique, Snp étant la différence entre Sp et Sn, $\Delta T$ la différence de température effective entre le premier côté 104 et le deuxième côté 105 à laquelle les jonctions thermoélectriques sont soumises, N le nombre de jonctions thermoélectriques du dispositif thermoélectrique, Sp le coefficient Seebeck du matériau de type P utilisé pour former par exemple chaque second plot 102, et Sn le coefficient Seebeck du matériau de type N utilisé pour former chaque premier plot 101 ;
- une puissance électrique utile $P_u$ pouvant être déterminée de la manière suivante (notée équation (3) par la suite) :

$$P_u = \frac{V_{oc}^2}{4 \times R_{int}}$$

L'équation (1) néglige les résistances électriques de contact et les résistances électriques des éléments de connexion 107 et des éléments de liaison 106 qui ont généralement des contributions négligeables devant les résistances électriques des plots N et P.

Pour disposer d'une puissance utile élevée, il faut donc avoir simultanément une tension de sortie élevée et une résistance électrique faible.

Pour tenter de parvenir à cela, il existe deux méthodes principales utilisant la technologie des films minces permettant de réaliser des dispositifs thermoélectriques microélectroniques à films minces compatibles avec les procédés de la microélectronique.

La première méthode est de type technologie « 2D » (pour « deux dimensions »), autrement dit planaire. Dans cette méthode, les premiers plots 101 et les seconds plots 102 évoqués ci-avant en lien avec la figure 1 se présentent sous la forme de lignes respectivement dopées N et P, reliées électriquement en série et thermiquement en parallèle. Cette technologie est généralement réalisée uniquement par les techniques de formation de films minces en microélectroniques, c'est-à-dire des valeurs d'épaisseur comprise entre 1 nm et 100 $\mu$m.

Ce type de méthode est bien adaptée à la fabrication des dispositifs thermoélectriques de type microcapteurs, mais elle n'est pas adaptée à la fabrication de dispositifs thermoélectriques destinés à générer de l'électricité selon l'effet Seebeck. En effet, les deux côtés thermiques, positionnés dans le plan du dispositif thermoélectronique obtenu en 2D, sont éloignés d'une distance correspondant à la longueur des lignes formant les premiers et deuxièmes plots. Ainsi, pour avoir $\Delta T$ de l'équation 3 (la différence de température effective entre le premier côté thermique et le deuxième côté thermique à laquelle les jonctions thermoélectriques sont soumises) élevé, il est nécessaire que les côtés thermiques soient aussi éloignés que possible et isolés thermiquement entre eux. Cela implique la formation de lignes formant les premiers et deuxièmes plots les plus longues possibles. Mais dans ce cas, la résistance électrique selon l'équation 1 augmente, ce qui grève la puissance utile d'après l'équation 3, ce qui n'est pas satisfaisant.

De plus, d'un point de vue de la fabrication, celle-ci nécessite l'enchaînement de plusieurs étapes de dépôts (matériaux thermoélectriques, matériaux isolants, les matériaux électriquement conducteurs...), de lithographies, de gravures, de recuits. Toutes ces opérations sont longues, pénibles et délicates à mettre en oeuvre, en sus d'être onéreuses.

La deuxième méthode est de type technologie « 3D » (pour « trois dimensions »), autrement dit orthogonale. Cette méthode peut être obtenue à l'aide d'un substrat unique massif, ou par l'empilement de substrats où chacun est obtenu par la technologie 2D précédemment décrite. L'architecture du dispositif thermoélectrique obtenu permet, dans le cadre de la génération d'énergie électrique, d'exploiter une source chaude (placée côté chaud) et une source froide (placée côté froid) agencées de manière opposée, notamment orthogonalement, au plan du ou des substrat(s). Une source froide présente une température strictement inférieure à la température que présente la source chaude. Autrement dit, les sources chaude et froide peuvent s'étendre de part et d'autre d'une paroi constituée par une plaque formée par le ou les substrat(s).

Ainsi, même si une telle architecture présente l'avantage d'offrir une résistance électrique faible du fait que la hauteur H de chacun des premiers et seconds plots est généralement de quelques micromètres, c'est-à-dire comprise entre 1 et 100 microns, dans le domaine de la microélectronique, elle présente l'inconvénient qu'il est difficile d'obtenir une différence de température satisfaisante pour générer une tension de sortie élevée puisque cette dernière est fonction de la différence de température, laquelle différence de température dépendant de la température de la source chaude et de la température de la source froide. Mais plus la source chaude et la source froide sont proches dans le cas d'une paroi très fine, plus il est difficile d'obtenir une différence de température élevée à exploiter dans le cadre de l'effet Seebeck.

De plus, d'un point de vue de la fabrication, dans le cas où la paroi est un empilement de substrats obtenus chacun par un technologie 2D, celle-ci nécessite l'enchaînement de plusieurs étapes de dépôts (matériaux thermoélectriques, matériaux isolants, les matériaux électriquement conducteurs...), de lithographies, de gravures, de recuits. Toutes ces opérations sont longues, pénibles et délicates à mettre en oeuvre, en sus d'être onéreuses.

D'un point de la fabrication toujours mais dans le cas où la paroi est un substrat massif, il est malheureusement nécessaire d'enchaîner là aussi beaucoup d'étapes de frittage, de polissage, de découpe, de métallisation, de recuit, de transfert autrement appelés « pick and place » selon la terminologie anglo-saxonne consacrée, etc... Il s'agit d'un procédé de fabrication complexe et qui, en outre, limite beaucoup la géométrie et la modularité du dispositif thermoélectrique fabriqué.

En ce sens, on comprend qu'il existe un besoin de fournir un procédé de fabrication permettant d'obtenir un dispositif thermoélectrique, en particulier adapté à constituer un générateur d'énergie pour la production d'énergie électrique en exploitant une différence de température à laquelle est soumis le dispositif thermoélectrique, qui présente une très bonne efficacité, une résistance électrique faible et qui puisse être utilisé avec une grande différence de températures entre les sources chaude et froide, où de plus ce procédé comprend avantageusement moins d'étapes que dans l'état de la technique cité, est plus simple et plus économique, permet d'offrir une grande modularité de forme et de conception du dispositif thermoélectrique fabriqué, diminue les pertes de matériaux, facilite l'intégration et l'interface, permet de mettre en oeuvre des assemblages complexes, est rapide à implémenter.

Ces besoins se présentent aussi pour la fabrication d'un dispositif thermoélectrique adapté à fonctionner en mode Peltier, c'est-à-dire pouvant être alimenté en énergie électrique de sorte à refroidir l'un de ses côtés parmi le premier côté thermique ou le deuxième côté thermique.

US2019131508 A1 décrit des dispositifs thermoélectriques et des procédés pour former des dispositifs thermoélectriques.

**Objet de l'invention**

La présente invention a pour but de proposer un procédé de fabrication d'un dispositif thermoélectrique répondant aux problématiques évoquées ci-dessus.

Ce but peut être atteint grâce à la mise en oeuvre d'un procédé de fabrication d'un dispositif thermoélectrique, lequel dispositif thermoélectrique comprend une pluralité de jonctions thermoélectriques où chaque jonction thermoélectrique d'une part est agencée entre un premier côté thermique et un deuxième côté thermique du dispositif thermoélectrique et d'autre part comprend un premier élément dopé selon un premier type de dopage s'étendant entre lesdits premier et deuxième côtés thermiques et un second élément dopé selon un deuxième type de dopage et s'étendant entre lesdits premier et deuxième côtés thermiques, le premier élément et le deuxième élément étant reliés électriquement entre eux au niveau de l'un desdits premier et deuxième côtés thermiques et permettant de générer un effet thermoélectrique, le procédé de fabrication comprenant :

- une étape a) de fabrication d'au moins une première pièce formée dans un premier matériau dopé selon le premier type de dopage et adoptant la forme d'un peigne délimitant une première base et une pluralité de premières branches sensiblement parallèles entre elles et s'étendant sensiblement orthogonalement à partir de la première base,
- une étape b) de fabrication d'au moins une deuxième pièce formée dans un deuxième matériau dopé selon le deuxième type de dopage adoptant la forme d'un peigne délimitant une deuxième base et une pluralité de deuxièmes branches sensiblement parallèles entre elles et s'étendant sensiblement orthogonalement à partir de la deuxième base,
- une étape c) d'assemblage durant laquelle la première pièce et la deuxième pièce sont assemblées l'une avec l'autre mécaniquement pour former un ensemble autoportant,
- une étape d) de connexion électrique dans laquelle l'extrémité distale de tout ou partie des premières branches de la première pièce sont connectées électriquement à la deuxième base de la deuxième pièce et dans laquelle l'extrémité distale de tout ou partie des deuxièmes branches de la deuxième pièce sont connectées électriquement à la première base de la première pièce,
- une étape e) de découpe dans laquelle la première base est sectionnée en au moins une première zone située entre la naissance de l'une des premières branches et le contact avec l'une des deuxièmes branches adjacentes et dans laquelle la deuxième base est sectionnée en au moins une deuxième zone située entre la naissance de l'une des deuxièmes branches et le contact avec l'une des premières branches, étape e) à l'issue de laquelle chaque première branche et chaque deuxième branche séparées par une première zone constituent respectivement le premier élément et le deuxième élément d'une jonction thermoélectrique électriquement connectés via la partie de la deuxième base reliant ladite première branche et ladite deuxième branche ainsi séparées par cette première zone, tandis que chaque première branche et chaque deuxième branche séparées par une deuxième zone constituent respectivement le premier élément et le deuxième élément d'une jonction thermoélectrique électriquement connectés via la partie de la première base reliant ladite première branche et ladite deuxième branche ainsi séparées par cette deuxième zone.

Certains aspects préférés mais non limitatifs de ce procédé de fabrication sont les suivants, ceux-ci pouvant être mis en oeuvre isolément ou en de manière combinée.

Après l'étape e), le procédé de fabrication comprend une étape f) de raccordement électrique dans laquelle les jonctions thermoélectriques créées à l'étape e) sont connectées électriquement entre elles de sorte à les raccorder en série et/ou en parallèles.

Durant l'étape e), l'aménagement d'une première zone et d'une deuxième zone de part et d'autre de l'une des premières branches, ou de l'une des deuxièmes branches, crée une jonction thermoélectrique en série avec toute autre jonction thermoélectrique également créée à l'étape e).

Les étapes c) et d) sont obtenues par une seule et même opération, dans laquelle l'extrémité distale d'au moins l'une des premières branches est connectée électriquement et mécaniquement avec la deuxième base et dans laquelle l'extrémité distale d'au moins l'une des deuxièmes branches est connectée électriquement et mécaniquement avec la première base.

L'étape a) consiste en une méthode de fabrication additive dans laquelle un matériau est déposé en passes successives sur un plateau, le résultat des dépôts successifs durant les différentes passes comprenant un premier peigne dont la forme correspond à la forme de chaque première pièce.

Une pluralité de premiers peignes solidarisés entre eux pour former un premier bloc d'un seul tenant sont obtenus durant l'étape a) et l'étape a) comprend une étape a1) de fractionnement dans laquelle ledit premier bloc est fractionné afin de délivrer ladite pluralité de premiers peignes sous forme unitaire séparés les uns des autres.

Le matériau utilisé dans la méthode de fabrication additive dans l'étape a) est le premier matériau dans lequel chaque première pièce est constituée.

L'étape b) consiste en une méthode de fabrication additive dans laquelle un matériau est déposé en passes successives sur un plateau, le résultat des dépôts successifs durant les différentes passes comprenant un deuxième peigne dont la forme correspond à la forme de chaque deuxième pièce.

Une pluralité de deuxièmes peignes solidarisés entre eux pour former un deuxième bloc d'un seul tenant sont obtenus durant l'étape b) et l'étape b) comprend une étape b1) de fractionnement dans laquelle ledit deuxième bloc est fractionné afin de délivrer ladite pluralité de deuxièmes peignes sous forme unitaire séparés les uns des autres.

Le matériau utilisé dans la méthode de fabrication additive dans l'étape b) est le deuxième matériau dans lequel chaque deuxième pièce est constituée.

Le matériau utilisé dans la méthode de fabrication additive de l'étape a) et le matériau utilisé dans la méthode de fabrication additive de l'étape b) sont identiques, et l'étape a) comprend une étape de dopage par implantation ou par traitement thermique afin de transformer le matériau utilisé dans la méthode de fabrication additive de l'étape a) en le premier matériau dans lequel l'au moins une première pièce est constituée, tandis que l'étape b) comprend une étape de dopage par implantation ou par traitement thermique afin de transformer le matériau utilisé dans la méthode de fabrication additive de l'étape b) en le deuxième matériau dans lequel l'au moins une deuxième pièce est constituée.

**Description sommaire des dessins**

D'autres aspects, buts, avantages et caractéristiques de l'invention apparaîtront mieux à la lecture de la description détaillée suivante de modes de réalisation préférés de celle-ci, donnée à titre d'exemple non limitatif, et faite en référence aux dessins annexés sur lesquels :

La figure 1 représente, selon une vue en coupe, un dispositif thermoélectrique selon l'art antérieur.

La figure 2 représente schématiquement un exemple de première pièce utilisable dans un exemple de procédé de fabrication selon l'invention, à l'étape a), la deuxième pièce présentant une forme identique à la forme de la première pièce.

La figure 3 représente schématiquement un exemple de première pièce utilisable dans un exemple de procédé de fabrication selon l'invention, à l'étape b).

La figure 4 représente l'assemblage de la première pièce et de la deuxième pièce à l'issue de l'étape c) et/ou d).

La figure 5 représente un exemple de situation après l'étape e).

La figure 6 représente un autre exemple de situation après l'étape e).

La figure 7 représente une variante à la figure 4 où la deuxième pièce présente une forme différente de la forme de la première pièce en ce qui concerne la largeur des branches.

La figure 8 représente, en perspective, une variante à la figure 4 où la deuxième pièce présente une épaisseur supérieure à l'épaisseur de la première pièce.

**Description détaillée**

Sur les figures 1 à 8 et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux.

Comme évoqué dans la partie état de la technique, le dispositif thermoélectrique fabriqué par la mise en oeuvre du procédé de fabrication qui va être décrit ci-après peut fonctionner en mode Seebeck : le dispositif thermoélectrique est alors un générateur d'énergie électrique, ou en mode Peltier : le dispositif thermoélectrique est alors un générateur d'énergie thermique. Ces modes de fonctionnement sont bien connus de l'homme du métier, et ne seront pas décrits plus en détails.

Dans la présente description, par « à base de », on entend « comporte majoritairement » ou est « constitué par ».

Dans la présente description, pour une dimension comprise entre deux valeurs, les bornes formées par ces deux valeurs sont incluses.

Par « sensiblement orthogonal », on entend dans la présente description « orthogonal » ou « orthogonal à plus ou moins 10° de tolérance ».

Par « sensiblement parallèle », on entend dans la présente description « parallèle » ou « parallèle à plus ou moins 10° de tolérance ».

Le procédé consiste à fabriquer un dispositif thermoélectrique 1, lequel dispositif thermoélectrique 1 comprend une pluralité de jonctions thermoélectriques 2.

Chaque jonction thermoélectrique 2 est agencée entre un premier côté thermique 3 et un deuxième côté thermique 4 du dispositif thermoélectrique 1. Chaque jonction thermoélectrique 2 comprend un premier élément 5 dopé selon un premier type de dopage s'étendant entre le premier côté thermique 3 et le deuxième côté thermique 4. Chaque jonction thermoélectrique 2 comprend aussi un second élément 6 dopé selon un deuxième type de dopage et s'étendant entre le premier côté thermique 3 et le deuxième côté thermique 4. Le premier élément 5 et le deuxième élément 6 sont reliés électriquement entre eux au niveau de l'un des premier et deuxième côtés thermiques 3, 4 et permettent de générer un effet thermoélectrique.

Une différence de température entre les premier et deuxième côtés thermiques 3, 4 peut être générée, ou exploitée, par le dispositif thermoélectrique 1 (et donc par l'au moins une jonction thermoélectrique 2) selon son mode de fonctionnement. Notamment, le premier côté thermique 3 est un « côté chaud » et le deuxième côté thermique 4 est un « côté froid », l'inverse est bien entendu possible. La différence de température est observable entre le premier côté thermique 3 et le deuxième côté thermique 4, le gradient de température aux bornes de la, ou de chacune des, jonctions thermoélectriques 2 est dépendant de cette différence de température.

Chaque jonction thermoélectrique 2 du dispositif thermoélectrique 1 est configurée pour générer un effet thermoélectrique, notamment lors du fonctionnement du dispositif thermoélectrique 1. En mode Seebeck, l'effet thermoélectrique est tel que l'au moins une jonction thermoélectrique 2 permet la génération d'une énergie électrique lorsqu'elle est soumise à une différence de température appliquée au dispositif thermoélectrique 1, notamment entre ses premier et deuxième côtés thermiques 3, 4. En mode Peltier, l'effet thermoélectrique est tel que l'au moins une jonction thermoélectrique 2 permet la génération d'une énergie thermique (différence de température entre les premier et deuxième côtés thermiques 3, 4) lorsqu'elle est soumise à une énergie électrique alimentant électriquement l'au moins une jonction thermoélectrique 2.

Ainsi, le procédé de fabrication comprend d'abord une étape a) de fabrication d'au moins une première pièce 10 formée dans un premier matériau dopé selon le premier type de dopage évoqué précédemment. En référence à la figure 2 par exemple, chaque première pièce 10 fabriquée à l'étape a) adopte la forme d'un peigne délimitant une première base 11 et une pluralité de premières branches 12 sensiblement parallèles entre elles et s'étendant sensiblement orthogonalement à partir de la première base 11.

Préférentiellement, le premier matériau mentionné ci-avant est choisi parmi $Bi_2Te_3$, Si, SiGe, MnSi, les matériaux de la famille des skutterudites (espèce minérale composée d'arséniure de cobalt et de nickel de formule $As_{3-x}$ avec des traces de S, Bi, Cu, Pb, Zn, Ag, Fe et Ni), Half-Heusler, etc.

De manière particulièrement avantageuse pour le présent procédé et afin de répondre aux problématiques mentionnées en lien avec l'art antérieur, dans un mode de réalisation particulier l'étape a) consiste en une méthode de fabrication additive, autrement appelée impression 3D, dans laquelle un matériau est déposé en passes successives sur un plateau, le résultat des dépôts successifs durant les différentes passes comprenant au moins un premier peigne tel que susmentionné au paragraphe précédent, c'est-à-dire dont la forme correspond à la forme de chaque première pièce 10. Le nombre de passe est relié à l'épaisseur, le choix des matériaux pouvant se faire de manière non exclusive parmi la liste donnée au paragraphe précédent.

La méthode de fabrication additive de l'étape a) peut par exemple correspondre aux technologies connues sous le nom « SLM » qui est l'acronyme de « Sélective Laser Melting » selon la terminologie anglo-saxonne consacrée ou sous le nom de « SLS » qui est l'acronyme pour « Selective Laser Sintering » selon la terminologie anglo-saxonne consacrée. D'autres techniques de fabrication additive peuvent être envisagées, telles que « Binder Jetting », « Electron Beam Melting », etc. Elles ont chacune leur spécificité et l'une ou l'autre technique peut être choisie en fonction de la nature du matériau à fabriquer, ces dispositions étant connues et classiques.

Dans une première variante, la méthode de fabrication additive de l'étape a) est paramétrée et réalisée de sorte que chaque peigne obtenu par cette méthode ait directement la forme du premier peigne suivant laquelle la première pièce 10 est conformée. Autrement dit, chacune des premières pièces 10 est directement fabriquée par la méthode de fabrication additive séparément des autres.

Dans une deuxième variante, la forme du peigne fabriqué par la méthode de fabrication additive de l'étape a) correspond à une pluralité de premiers peignes solidarisés entre eux pour former un premier bloc d'un seul tenant. Dans ce cas, l'étape a) comprend une étape a1) de fractionnement dans laquelle ce premier bloc est fractionné afin de délivrer la pluralité de premiers peignes sous forme unitaire séparés les uns des autres. Le fractionnement mis en oeuvre à l'étape a1) peut par exemple se pratiquer par un usinage mécanique, par jet d'eau, ou toute autre technique équivalente et adaptée à la nature et l'épaisseur du matériau à fractionner.

De plus, le procédé de fabrication comprend une étape b) de fabrication d'au moins une deuxième pièce 20 formée dans un deuxième matériau dopé selon le deuxième type de dopage évoqué précédemment. En référence à la figure 3 par exemple, chaque deuxième pièce 20 fabriquée à l'étape b) adopte la forme d'un peigne délimitant une deuxième base 21 et une pluralité de deuxièmes branches 22 sensiblement parallèles entre elles et s'étendant sensiblement orthogonalement à partir de la deuxième base 21.

Préférentiellement, le deuxième matériau mentionné ci-avant est choisi parmi $Bi_2Te_3$, Si, SiGe, MnSi, les matériaux de la famille des skutterudites, Half-Heusler, etc.

De manière particulièrement avantageuse pour le présent procédé et afin de répondre aux problématiques mentionnées en lien avec l'art antérieur, dans un mode de réalisation particulier l'étape b) consiste aussi en une méthode de fabrication additive, autrement appelée impression 3D, dans laquelle un matériau est déposé en passes successives sur un plateau, le résultat des dépôts successifs durant les différentes passes comprenant au moins un deuxième peigne tel que susmentionné au paragraphe précédent, c'est-à-dire dont la forme correspond à la forme de chaque deuxième pièce 20. Le nombre de passe est relié à l'épaisseur, le choix des matériaux pouvant se faire de manière non exclusive parmi la liste donnée au paragraphe précédent.

La méthode de fabrication additive de l'étape b) peut par exemple correspondre aux technologies connues sous le nom « SLM » qui est l'acronyme de « Sélective Laser Melting » selon la terminologie anglo-saxonne consacrée ou sous le nom de « SLS » qui est l'acronyme pour « Selective Laser Sintering » selon la terminologie anglo-saxonne consacrée. D'autres techniques de fabrication additive peuvent être envisagées, telles que « Binder Jetting », « Electron Beam Melting », etc. Elles ont chacune leur spécificité et l'une ou l'autre technique peut être choisie en fonction de la nature du matériau à fabriquer, ces dispositions étant connues et classiques.

Dans une première variante, la méthode de fabrication additive de l'étape b) est paramétrée et réalisée de sorte que chaque peigne obtenu par cette méthode ait directement la forme du deuxième peigne suivant laquelle la deuxième pièce 20 est conformée. Autrement dit, chacune des deuxièmes pièces 20 est directement fabriquée par la méthode de fabrication additive séparément des autres.

Dans une deuxième variante, la forme du peigne fabriqué par la méthode de fabrication additive de l'étape b) correspond à une pluralité de deuxièmes peignes solidarisés entre eux pour former un deuxième bloc d'un seul tenant. Dans ce cas, l'étape b) comprend une étape b1) de fractionnement dans laquelle ce deuxième bloc est fractionné afin de délivrer la pluralité de deuxièmes peignes sous forme unitaire séparés les uns des autres. Le fractionnement mis en oeuvre à l'étape b1) peut par exemple se pratiquer par un usinage mécanique, par jet d'eau, ou toute autre technique équivalente et adaptée à la nature et l'épaisseur du matériau à fractionner.

Dans une première variante, le matériau utilisé dans la méthode de fabrication additive dans l'étape a) est le premier matériau dans lequel chaque première pièce 10 est constituée. Le matériau utilisé dans la méthode de fabrication additive dans l'étape b) peut aussi être le deuxième matériau dans lequel chaque deuxième pièce 20 est constituée.

Alternativement, dans une deuxième variante le matériau utilisé dans la méthode de fabrication additive de l'étape a) et le matériau utilisé dans la méthode de fabrication additive de l'étape b) sont identiques. Des exemples de matériau utilisable dans cette variante sont le Si ou le SiGe. Dans ce cas, l'étape a) comprend une étape de dopage par implantation ou par traitement thermique, ces techniques étant classiques et connues de l'Homme du Métier, afin de transformer le matériau utilisé dans la méthode de fabrication additive de l'étape a) en le premier matériau dans lequel l'au moins une première pièce 10 est constituée et l'étape b) comprend une étape de dopage par implantation ou par traitement thermique, ces techniques étant classiques et connues de l'Homme du Métier, afin de transformer le matériau utilisé dans la méthode de fabrication additive de l'étape b) en le deuxième matériau dans lequel l'au moins une deuxième pièce 20 est constituée.

En particulier, la première pièce 10 et la deuxième pièce 20 sont chacune formée en, ou comportent chacun un, matériau thermoélectrique. Il en résulte que les premières branches 12 et la première base 11 sont formés en matériau thermoélectrique et les deuxièmes branches 22 et la deuxième base 12 sont formés en matériau thermoélectrique. Le premier matériau thermoélectrique de la première pièce 10 présente des propriétés thermoélectriques différentes de celles du deuxième matériau thermoélectrique de la deuxième pièce pour assurer l'effet Peltier, ou Seebeck, recherché. De préférence, le premier matériau thermoélectrique est de type N, et le deuxième matériau thermoélectrique est de type P. Le premier matériau thermoélectrique de type N permet de favoriser le déplacement des électrons. Le deuxième matériau thermoélectrique de type P permet de favoriser le déplacement des trous. Selon une autre formulation le premier matériau thermoélectrique de type N présente un coefficient Seebeck strictement négatif, et le deuxième matériau thermoélectrique de type P présente un coefficient Seebeck strictement positif. De préférence, pour favoriser le déplacement des électrons, le premier matériau thermoélectrique de la première pièce 10 est un, ou est à base d'un, matériau dopé de type N, comme par exemple un alliage silicium-germanium (SiGe) dopé par du phosphore ou du polysilicium dopé de type N. De manière générale, le dopant de type N peut être du phosphore ou de l'arsenic. De préférence, pour favoriser le déplacement des trous, le deuxième matériau thermoélectrique de la deuxième pièce 20 est un, ou est à base d'un, matériau dopé de type P, comme par exemple un alliage silicium-germanium (SiGe) dopé par du bore ou encore du polysilicium dopé de type P. De manière générale, le dopant de type P est préférentiellement du bore. Par dopage, on parle de dopage électrique.

Après les étapes a et b) telles que décrites ci-avant, le procédé de fabrication comprend une étape c) d'assemblage durant laquelle la première pièce 10 et la deuxième pièce 20 sont assemblées l'une avec l'autre mécaniquement pour former un ensemble autoportant. Pour réaliser cet assemblage, il est possible de solidariser les extrémités distales 13 d'au moins deux, préférentiellement toutes les, premières branches 12 de la première pièce 10 à la deuxième base 21 de la deuxième pièce 20 et/ou de solidariser les extrémités distales 23 d'au moins deux, préférentiellement toutes les, deuxièmes branches 22 de la deuxième pièce 20 à la première base 11 de la première pièce 10.

Le procédé de fabrication comprend aussi une étape d) de connexion électrique dans laquelle l'extrémité distale 13 de tout ou partie des premières branches 12 de la première pièce 10 sont connectées électriquement à la deuxième base 21 de la deuxième pièce 20 et l'extrémité distale 23 de tout ou partie des deuxièmes branches 22 de la deuxième pièce 20 sont connectées électriquement à la première base 11 de la première pièce 10.

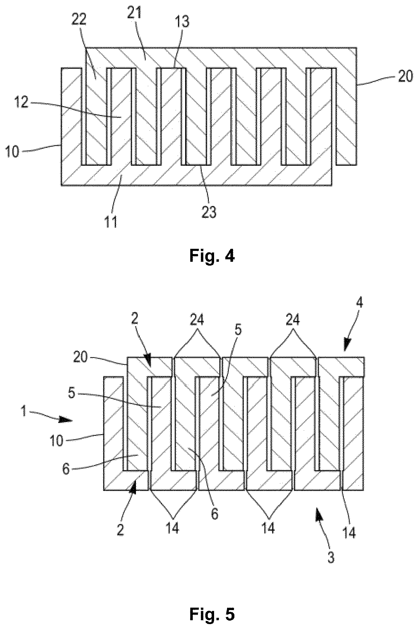

Dans une première variante telle qu'illustrée à la figure 4, l'étape c) et d) sont obtenues par une seule et même opération, dans laquelle l'extrémité distale d'au moins l'une des premières branches 12 est connectée électriquement et mécaniquement avec la deuxième base 21 et l'extrémité distale 23 d'au moins l'une des deuxièmes branches 22 est connectée électriquement et mécaniquement avec la première base 11. A titre d'exemple, cette opération peut être obtenue par une technique de soudage laser par exemple. Un avantage de cette variante est d'être efficace, économique et de limiter le nombre d'étapes du procédé de fabrication. Les paramètres du soudage laser dépendent de la nature des matériaux thermoélectriques en question.

Il reste toutefois qu'il est possible dans une deuxième variante alternative de réaliser l'étape c) et l'étape d) successivement. Par exemple, il est possible de réaliser l'étape c) par une technique de collage puis de réaliser l'étape d) en réalisant un dépôt adapté d'un matériau électriquement conducteur dans la zone de liaison des extrémités distales 13 des premières branches 12 avec la deuxième base 21 et dans la zone de liaison des extrémités distales 23 des deuxièmes branches 22 avec la première branche 11. Pour la mise en oeuvre d'une telle étape d), la liaison électrique entre les premières branches 12 et la deuxième base 21 et entre les deuxièmes branches 22 et la première base 11 peut, par exemple, être formée par un élément de liaison électrique en matériau métallique, ou en un alliage métallique, par exemple choisi parmi l'aluminium, le cuivre avec un alliage SnAg, le nickel avec de l'or, et le titane.

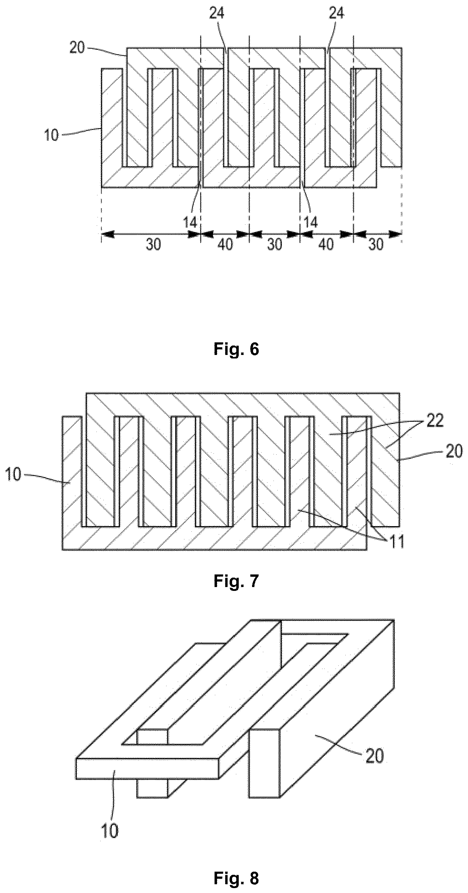

Par ailleurs, une fois l'étape d) terminée, le procédé de fabrication comprend, en référence à la figure 5 et à la figure 6 qui illustrent deux variantes possibles, une étape e) de découpe dans laquelle la première base 11 est sectionnée en au moins une première zone 14 située entre la naissance (c'est-à-dire la zone de liaison entre la première base 11 et la première branche 12 correspondante) de l'une des premières branches 12 et le contact avec l'une des deuxièmes branches 22 adjacentes et dans laquelle la deuxième base 21 est sectionnée en au moins une deuxième zone 24 située entre la naissance (c'est-à-dire la zone de liaison entre la deuxième base 21 et la deuxième branche 22 correspondante) de l'une des deuxièmes branches 22 et le contact avec l'une des premières branches 11.

A l'issue de l'étape e), chaque première branche 12 et chaque deuxième branche 22 séparées par une première zone 14 constituent respectivement le premier élément 5 et le deuxième élément 6 d'une jonction thermoélectrique 2 électriquement connectés entre eux via la partie de la deuxième base 21 reliant cette première branche 12 et cette deuxième branche 22 ainsi séparées par cette première zone 14. Par ailleurs, toujours à l'issue de l'étape e), chaque première branche 12 et chaque deuxième branche 22 séparées par une deuxième zone 24 constituent respectivement le premier élément 5 et le deuxième élément 6 d'une jonction thermoélectrique 2 électriquement connectés via la partie de la première base 11 reliant cette première branche 12 et cette deuxième branche 22 ainsi séparées par cette deuxième zone 24.

La découpe mise en oeuvre à l'étape e) peut par exemple se pratiquer par un usinage mécanique, par jet d'eau, ou toute autre technique équivalente et adaptée à la nature et l'épaisseur du matériau à découper.

De manière générale, durant l'étape e), l'aménagement d'une première zone 14 et d'une deuxième zone 24 de part et d'autre de l'une donnée des premières branches 12, ou de l'une donnée des deuxièmes branches 22, crée une jonction thermoélectrique 2 en série avec toute autre jonction thermoélectrique également créée à l'étape e).

Sur la figure 5, il est illustré le cas où toutes les paires de branches comprenant une première branche 12 et une deuxième branche 22 adjacente sont séparées des autres paires par une première zone 14 ménagée dans la première base 21 et où toutes les paires de branches comprenant une première branche 12 et une deuxième branche 22 adjacente sont séparées des autres paires par une deuxième zone 24 ménagée dans la deuxième base 21. Une telle organisation permet que toutes les jonctions thermoélectriques soient connectées électriquement en série entres elles et soient thermiquement connectées entre elles en parallèle.

La figure 6 représente une mise en oeuvre alternative où seules certaines premières zones 14 sont ménagées dans la première base 11 et seules certaines deuxièmes zones 24 sont ménagées dans la deuxième base 21, afin de conserver des jonctions thermoélectriques 2 connectées électriquement en parallèle entre elles. Par exemple, sur la figure 5, les jonctions thermoélectriques situées dans les emplacements 30 sont connectées entre elles en parallèle tandis que les jonctions thermoélectriques situées dans les emplacements 40 sont connectées en série entre elles.

Cela a pour intention de montrer qu'il est possible de combiner des connexions série et des connexions en parallèle pour optimiser les performances électriques de sortie du dispositif thermoélectrique 1 fabriqué. En effet, cela offre la possibilité de relier électriquement à façon les différentes jonctions thermoélectriques. Usuellement comme c'est le cas sur la figure 5, toutes les jonctions thermoélectriques sont reliées électriquement en série. Mais ceci peut amener à obtenir des tensions de sortie élevées (plusieurs de volts voire dizaines de volts), ce qui peut être incompatible avec certaines électroniques associées pour lesquelles les tensions requises sont généralement de quelques volts. La possibilité de relier certaines jonctions thermoélectriques en parallèle permet de diminuer cette tension de sortie du dispositif thermoélectrique 1 tout en maintenant la puissance générée.

De plus, après l'étape e), le procédé de fabrication comprend une étape f) de raccordement électrique dans laquelle les jonctions thermoélectriques 2 créées à l'étape e) sont connectées électriquement entre elles de sorte à les raccorder en série et/ou en parallèles. Selon un premier mode en oeuvre, le raccordement électrique se fait naturellement lorsque les jonctions sont reliées mécaniquement entre elles, par exemple par soudage. Alternativement, dans un deuxième mode de mise en oeuvre, le raccordement électrique des jonctions s'accompagne d'une étape de raccordement électrique, par exemple via un dépôt d'un métal électriquement conducteur agencé de manière idoine.

Si sur les figures précédentes la forme de la première pièce 10 est identique à celle de la deuxième pièce 20, la figure 7 a pour intention d'illustrer que la deuxième pièce 20 peut éventuellement présenter une forme différente de la forme de la première pièce 10 en ce qui concerne la largeur des branches. Cela permet d'avoir une influence sur les équations 1 et 3. A titre d'exemple tel que cela est visible sur la figure 7, la largeur des deuxièmes branches 22 peut être supérieure à la largeur des premières branches 11.

De manière combinée ou alternative à ce qui vient d'être décrit en lien avec la figure 7, si sur les figures 2 à 6 la forme de la première pièce 10 est identique à celle de la deuxième pièce 20, la figure 10 a pour intention d'illustrer que la deuxième pièce 20 peut éventuellement présenter une forme différente de la forme de la première pièce 10 en ce qui concerne l'épaisseur des pièces 10, 20. Cela permet aussi d'avoir une influence sur les équations 1 et 3. A titre d'exemple tel que cela est visible sur la figure 8, l'épaisseur de la deuxième pièce 20 est supérieure à l'épaisseur de la première pièce 10.

Le procédé de fabrication qui vient d'être décrit présente les avantages suivants :

- il permet d'obtenir un dispositif thermoélectrique, en particulier adapté à constituer un générateur d'énergie pour la production d'énergie électrique en exploitant une différence de température à laquelle est soumis le dispositif thermoélectrique, qui présente une très bonne efficacité, une résistance électrique faible et qui puisse être utilisé avec une grande différence de températures entre les sources chaude et froide,
- il comprend avantageusement un nombre faible d'étapes,
- il est simple et économique,
- il permet d'offrir une grande modularité de forme et de conception du dispositif thermoélectrique fabriqué,
- il diminue les pertes de matériaux,
- il facilite l'intégration et l'interface,
- il permet de mettre en oeuvre des assemblages complexes,
- il est rapide à exécuter.

## Revendications

1. Procédé de fabrication d'un dispositif thermoélectrique (1), lequel dispositif thermoélectrique (1) comprend une pluralité de jonctions thermoélectriques (2) où chaque jonction thermoélectrique (2) d'une part est agencée entre un premier côté thermique (3) et un deuxième côté thermique (4) du dispositif thermoélectrique (1) et d'autre part comprend un premier élément (5) dopé selon un premier type de dopage s'étendant entre lesdits premier et deuxième côtés thermiques (3, 4) et un second élément (6) dopé selon un deuxième type de dopage et s'étendant entre lesdits premier et deuxième côtés thermiques (3, 4), le premier élément (5) et le deuxième élément (6) étant reliés électriquement entre eux au niveau de l'un desdits premier et deuxième côtés thermiques (3, 4) et permettant de générer un effet thermoélectrique, le procédé de fabrication comprenant :

  - une étape a) de fabrication d'au moins une première pièce (10) formée dans un premier matériau dopé selon le premier type de dopage et adoptant la forme d'un peigne délimitant une première base (11) et une pluralité de premières branches (12) sensiblement parallèles entre elles et s'étendant sensiblement orthogonalement à partir de la première base (11),
  - une étape b) de fabrication d'au moins une deuxième pièce (20) formée dans un deuxième matériau dopé selon le deuxième type de dopage adoptant la forme d'un peigne délimitant une deuxième base (21) et une pluralité de deuxièmes branches (22) sensiblement parallèles entre elles et s'étendant sensiblement orthogonalement à partir de la deuxième base (21),
  - une étape c) d'assemblage durant laquelle la première pièce (10) et la deuxième pièce (20) sont assemblées l'une avec l'autre mécaniquement pour former un ensemble autoportant, **caractérisé par**
  - une étape d) de connexion électrique dans laquelle l'extrémité distale (13) de tout ou partie des premières branches (12) de la première pièce (10) sont connectées électriquement à la deuxième base (21) de la deuxième pièce (20) et dans laquelle l'extrémité distale (23) de tout ou partie des deuxièmes branches (22) de la deuxième pièce (20) sont connectées électriquement à la première base (11) de la première pièce (10),

- une étape e) de découpe dans laquelle la première base (11) est sectionnée en au moins une première zone (14) située entre la naissance de l'une des premières branches (12) et le contact avec l'une des deuxièmes branches (22) adjacentes et dans laquelle la deuxième base (21) est sectionnée en au moins une deuxième zone (24) située entre la naissance de l'une des deuxièmes branches (22) et le contact avec l'une des premières branches (12), étape e) à l'issue de laquelle chaque première branche (12) et chaque deuxième branche (22) séparées par une première zone (14) constituent respectivement le premier élément (5) et le deuxième élément (6) d'une jonction thermoélectrique (2) électriquement connectés via la partie de la deuxième base (21) reliant ladite première branche (12) et ladite deuxième branche (22) ainsi séparées par cette première zone (14), tandis que chaque première branche (12) et chaque deuxième branche (22) séparées par une deuxième zone (24) constituent respectivement le premier élément (5) et le deuxième élément (6) d'une jonction thermoélectrique (2) électriquement connectés via la partie de la première base (11) reliant ladite première branche (12) et ladite deuxième branche (22) ainsi séparées par cette deuxième zone (24).

2. Procédé de fabrication selon la revendication 1, dans lequel après l'étape e), le procédé de fabrication comprend une étape f) de raccordement électrique dans laquelle les jonctions thermoélectriques (2) créées à l'étape e) sont connectées électriquement entre elles de sorte à les raccorder en série et/ou en parallèles.

3. Procédé de fabrication selon l'une des revendications 1 ou 2, dans lequel durant l'étape e), l'aménagement d'une première zone (14) et d'une deuxième zone (24) de part et d'autre de l'une des premières branches (12), ou de l'une des deuxièmes branches (22), crée une jonction thermoélectrique (2) en série avec toute autre jonction thermoélectrique (2) également créée à l'étape e).

4. Procédé de fabrication selon l'une des revendications 1 à 3, dans lequel les étapes c) et d) sont obtenues par une seule et même opération, dans laquelle l'extrémité distale (13) d'au moins l'une des premières branches (12) est connectée électriquement et mécaniquement avec la deuxième base (21) et dans laquelle l'extrémité distale (23) d'au moins l'une des deuxièmes branches (22) est connectée électriquement et mécaniquement avec la première base (11).

5. Procédé de fabrication selon l'une des revendications 1 à 4, dans lequel l'étape a) consiste en une méthode de fabrication additive dans laquelle un matériau est déposé en passes successives sur un plateau, le résultat des dépôts successifs durant les différentes passes comprenant un premier peigne dont la forme correspond à la forme de chaque première pièce (10).

6. Procédé de fabrication selon la revendication 5, dans lequel une pluralité de premiers peignes solidarisés entre eux pour former un premier bloc d'un seul tenant sont obtenus durant l'étape a) et l'étape a) comprend une étape a1) de fractionnement dans laquelle ledit premier bloc est fractionné afin de délivrer ladite pluralité de premiers peignes sous forme unitaire séparés les uns des autres.

7. Procédé de fabrication selon l'une des revendications 5 ou 6, dans lequel le matériau utilisé dans la méthode de fabrication additive dans l'étape a) est le premier matériau dans lequel chaque première pièce (10) est constituée.

8. Procédé de fabrication selon l'une des revendications 1 à 7, dans lequel l'étape b) consiste en une méthode de fabrication additive dans laquelle un matériau est déposé en passes successives sur un plateau, le résultat des dépôts successifs durant les différentes passes comprenant un deuxième peigne dont la forme correspond à la forme de chaque deuxième pièce (20).

9. Procédé de fabrication selon la revendication 8, dans lequel une pluralité de deuxièmes peignes solidarisés entre eux pour former un deuxième bloc d'un seul tenant sont obtenus durant l'étape b) et l'étape b) comprend une étape b1) de fractionnement dans laquelle ledit deuxième bloc est fractionné afin de délivrer ladite pluralité de deuxièmes peignes sous forme unitaire séparés les uns des autres.

10. Procédé de fabrication selon l'une des revendications 8 ou 9, dans lequel le matériau utilisé dans la méthode de fabrication additive dans l'étape b) est le deuxième matériau dans lequel chaque deuxième pièce (20) est constituée.

11. Procédé de fabrication selon l'une des revendications 5 ou 6 et selon l'une des revendications 8 ou 9, dans lequel le matériau utilisé dans la méthode de fabrication additive de l'étape a) et le matériau utilisé dans la méthode de fabrication additive de l'étape b) sont identiques, dans lequel l'étape a) comprend une étape de dopage par implantation ou par traitement thermique afin de transformer le matériau utilisé dans la méthode de fabrication additive de l'étape a) en le premier matériau dans lequel l'au moins une première pièce (10) est constituée, et dans lequel l'étape b) comprend une étape de dopage par implantation ou par traitement thermique afin de transformer le matériau utilisé dans la méthode de fabrication additive de l'étape b) en le deuxième matériau dans lequel l'au moins une deuxième pièce (20) est constituée.

## Patentansprüche

1. Verfahren zur Herstellung einer thermoelektrischen Vorrichtung (1), wobei die thermoelektrische Vorrichtung (1) eine Vielzahl von thermoelektrischen Übergängen (2) umfasst, wobei jeder thermoelektrische Übergang (2) einerseits zwischen einer ersten thermischen Seite (3) und einer zweiten thermischen Seite (4) der thermoelektrischen Vorrichtung (1) angeordnet ist und andererseits ein erstes Element (5) umfasst, das gemäß einem ersten Dotierungstyp dotiert ist, und sich zwischen der ersten und der zweiten thermischen Seite (3, 4) und einem zweiten Element (6) erstreckt, das gemäß einem zweiten Dotierungstyp dotiert ist, und sich zwischen der ersten und der zweiten thermischen Seite (3, 4) erstreckt, wobei das erste Element (5) und das zweite Element (6) im Bereich einer der ersten und zweiten thermischen Seiten (3, 4) elektrisch miteinander verbunden sind, und ermöglichen, einen thermoelektrischen Effekt zu erzeugen, wobei das Herstellungsverfahren umfasst:

- einen Schritt a) zur Herstellung mindestens eines ersten Teils (10), das aus einem ersten dotierten Material gemäß dem ersten Dotierungstyp gebildet ist und die Form eines Kamms annimmt, der eine erste Basis (11) und eine Vielzahl von ersten Zweigen (12) eingrenzt, die im Wesentlichen parallel zueinander sind und sich im Wesentlichen orthogonal von der ersten Basis (11) aus erstrecken,
- einen Schritt b) zur Herstellung mindestens eines zweiten Teils (20), das aus einem zweiten dotierten Material gemäß dem zweiten Dotierungstyp gebildet ist und die Form eines Kamms annimmt, der eine zweite Basis (21) und eine Vielzahl von zweiten Zweigen (22) eingrenzt, die im Wesentlichen parallel zueinander sind, und sich im Wesentlichen orthogonal von der zweiten Basis (21) aus erstrecken,
- einen Schritt c) des Zusammenfügens, wobei das erste Teil (10) und das zweite Teil (20) mechanisch miteinander zusammengefügt werden, um eine selbsttragende Anordnung zu bilden,

**gekennzeichnet durch**

- einen Schritt d) der elektrischen Verbindung, wobei das distale Ende (13) aller oder eines Teilstücks der ersten Zweige (12) des ersten Teils (10) elektrisch mit der zweiten Basis (21) des zweiten Teils (20) verbunden werden, und wobei das distale Ende (23) aller oder eines Teilstücks der zweiten Zweige (22) des zweiten Teils (20) elektrisch mit der ersten Basis (11) des ersten Teils (10) verbunden werden,
- einen Schritt e) des Zuschneidens, wobei die erste Basis (11) in mindestens einen ersten Bereich (14) unterteilt wird, der sich zwischen dem Anfang eines der ersten Zweige (12) und dem Kontakt mit einem der benachbarten zweiten Zweige (22) befindet, und wobei die zweite Basis (21) in mindestens einen zweiten Bereich (24) unterteilt wird, der sich zwischen dem Anfang eines der zweiten Zweige (22) und dem Kontakt mit einem der ersten Zweige (12) befindet, wobei nach Abschluss von Schritt e) jeder erste Zweig (12) und jeder zweite Zweig (22), die durch einen ersten Bereich (14) getrennt sind, das erste Element (5) beziehungsweise das zweite Element (6) eines thermoelektrischen Übergangs (2) ausmachen, die elektrisch über das Teilstück der zweiten Basis (21) verbunden sind, die den ersten Zweig (12) und den zweiten Zweig (22) verbindet, die so durch diesen ersten Bereich (14) getrennt sind, wobei jeder erste Zweig (12) und jeder zweite Zweig (22), die durch einen zweiten Bereich (24) getrennt sind, jeweils das erste Element (5) beziehungsweise das zweite Element (6) eines thermoelektrischen Übergangs (2) ausmachen, die über das Teilstück der ersten Basis (11) verbunden sind, das den ersten Zweig (12) und den zweiten Zweig (22) elektrisch verbindet, die so durch diesen zweiten Bereich (24) getrennt sind.

2. Herstellungsverfahren nach Anspruch 1, wobei, nach Schritt e), das Herstellungsverfahren einen elektrischen Schritt f) des Anschließens umfasst, wobei die in Schritt e) erzeugten thermoelektrischen Übergänge (2) elektrisch miteinander verbunden werden, um sie in Reihe und/oder parallel anzuschließen.

3. Herstellungsverfahren nach einem der Ansprüche 1 oder 2, wobei in Schritt e) die Einrichtung eines ersten Bereichs (14) und eines zweiten Bereichs (24) auf beiden Seiten eines der ersten Zweige (12) oder eines der zweiten Zweige (22) einen thermoelektrischen Übergang (2) in Reihe mit jedem anderen thermoelektrischen Übergang (2) erzeugt, der ebenfalls in Schritt e) erzeugt wird.

4. Herstellungsverfahren nach einem der Ansprüche 1 bis 3, wobei die Schritte c) und d) durch einen einzigen Arbeitsgang erhalten werden, wobei das distale Ende (13) mindestens einer der ersten Zweige (12) elektrisch und mechanisch mit der zweiten Basis (21) verbunden ist und wobei das distale Ende (23) mindestens einer der zweiten Zweige (22) elektrisch und mechanisch mit der ersten Basis (11) verbunden ist.

5. Herstellungsverfahren nach einem der Ansprüche 1 bis 4, wobei der Schritt a) aus einer additiven Herstellungsmethode besteht, wobei ein Material in aufeinanderfolgenden Durchgängen auf einer Platte abgeschieden wird, wobei das Ergebnis der aufeinanderfolgenden Abscheidungen während der verschiedenen Durchgänge einen ersten Kamm umfasst, dessen Form der Form jedes ersten Teils (10) entspricht.

6. Herstellungsverfahren nach Anspruch 5, wobei eine Vielzahl von ersten Kämmen, die miteinander verbunden sind, um einen ersten einteiligen Block zu bilden, in Schritt a) erhalten werden, und wobei der Schritt a) einen Schritt a1) der Fraktionierung umfasst, wobei der erste Block fraktioniert wird, um die Vielzahl von ersten Kämmen in einheitlicher, voneinander getrennter Form zu liefern.

7. Herstellungsverfahren nach einem der Ansprüche 5 oder 6, wobei das Material, das in der additiven Herstellungsmethode in Schritt a) verwendet wurde, das erste Material ist, aus dem jedes erste Teil (10) gemacht ist.

8. Herstellungsverfahren nach einem der Ansprüche 1 bis 7, wobei der Schritt b) aus einer additiven Herstellungsmethode besteht, wobei ein Material in aufeinanderfolgenden Durchgängen auf einer Platte abgeschieden wird, wobei das Ergebnis der aufeinanderfolgenden Abscheidungen während der verschiedenen Durchgänge einen zweiten Kamm umfasst, dessen Form der Form jedes zweiten Teils (20) entspricht.

9. Herstellungsverfahren nach Anspruch 8, wobei eine Vielzahl von zweiten Kämmen, die miteinander verbunden sind, um einen zweiten einteiligen Block zu bilden, in Schritt b) erhalten werden und der Schritt b) einen Schritt b1) der Fraktionierung umfasst, wobei der zweite Block fraktioniert wird, um die Vielzahl von zweiten Kämmen in einheitlicher, voneinander getrennter Form zu liefern.

10. Herstellungsverfahren nach einem der Ansprüche 8 oder 9, wobei das Material, das in der additiven Herstellungsmethode in Schritt b) verwendet wurde, das zweite Material ist, aus dem jedes zweite Teil (20) gemacht ist.

11. Herstellungsverfahren nach einem der Ansprüche 5 oder 6 und nach einem der Ansprüche 8 oder 9, wobei das Material, das in der additiven Herstellungsmethode in Schritt a) verwendet wurde und das Material, das in der additiven Herstellungsmethode in Schritt b) verwendet wurde, identisch sind, wobei der Schritt a) einen Schritt der Dotierung durch Implantation oder Wärmebehandlung umfasst, um das Material, das in der additiven Herstellungsmethode in Schritt a) verwendet wurde, in das erste Material umzuwandeln, aus dem das mindestens eine erste Teil (10) gemacht ist, und wobei der Schritt b) einen Schritt der Dotierung durch Implantation oder Wärmebehandlung umfasst, um das Material, das in der additiven Herstellungsmethode in Schritt b) verwendet wurde, in das zweite Material umzuwandeln, aus dem das mindestens eine zweite Teil (20) gemacht ist.

## Claims

1. A method for manufacturing a thermoelectric device (1), said thermoelectric device (1) comprises a plurality of thermoelectric junctions (2) where each thermoelectric junction (2), on the one hand, is arranged between a first thermal side (3) and a second thermal side (4) of the thermoelectric device (1) and comprises, on the other hand, a first element (5) doped according to a first doping type and extending between said first and second thermal sides (3, 4) and a second element (6) doped according to a second doping type and extending between said first and second thermal sides (3, 4), the first element (5) and the second element (6) being electrically connected to each other at one of said first and second thermal sides (3, 4) and making it possible to generate a thermoelectric effect, the manufacturing method comprising:

   - a step a) of manufacturing at least one first part (10) formed in a first material doped according to the first doping type and adopting the shape of a comb delimiting a first base (11) and a plurality of first legs (12) substantially parallel to each other and extending substantially orthogonally from the first base (11),
   - a step b) of manufacturing at least one second part (20) formed in a second material doped according to the second doping type adopting the shape of a comb delimiting a second base (21) and a plurality of second legs (22) substantially parallel to each other and extending substantially orthogonally from the second base (21),

- an assembling step c) during which the first part (10) and the second part (20) are mechanically assembled with one another in order to form a self-standing assembly,
**characterized by**
- an electrical connection step d) in which the distal end (13) of all or part of the first legs (12) of the first part (10) are electrically connected to the second base (21) of the second part (20) and in which the distal end (23) of all or part of the second legs (22) of the second part (20) are electrically connected to the first base (11) of the first part (10),
- a cutting step e) in which the first base (11) is sectioned in at least one first area (14) located between the root of one of the first legs (12) and the contact with one of the second adjacent legs (22) and in which the second base (21) is sectioned in at least one second area (24) located between the root of one of the second legs (22) and the contact with one of the first legs (12), on completion of which step e) each first leg (12) and each second leg (22) separated by a first area (14) constitute respectively the first element (5) and the second element (6) of a thermoelectric junction (2) electrically connected via the portion of the second base (21) connecting said first leg (12) and said second leg (22) thus separated by this first area (14), while each first leg (12) and each second leg (22) separated by a second area (24) respectively constitute the first element (5) and the second element (6) of a thermoelectric junction (2) electrically connected via the portion of the first base (11) connecting said first leg (12) and said second leg (22) thus separated by this second area (24).

2. The manufacturing method according to claim 1, wherein after step e), the manufacturing method comprises an electrical connecting step f) in which the thermoelectric junctions (2) created in step e) are electrically connected to each other so as to couple them in series and/or in parallel.

3. The manufacturing method according to any of claims 1 or 2, wherein during step e), the arrangement of a first area (14) and a second area (24) on either side of one of the first legs (12), or of one of the second legs (22), creates a thermoelectric junction (2) in series with any other thermoelectric junction (2) also created during step e).

4. The manufacturing method according to any of claims 1 to 3, wherein steps c) and d) are obtained by a single and same operation, in which the distal end (13) of at least one of the first legs (12) is electrically and mechanically connected with the second base (21) and in which the distal end (23) of at least one of the second legs (22) is electrically and mechanically connected with the first base (11).

5. The manufacturing method according to any of claims 1 to 4, wherein step a) consists of an additive manufacturing method in which a material is deposited in successive passes on a tray, the result of the successive deposits during the different passes comprising a first comb whose shape corresponds to the shape of each first part (10).

6. The manufacturing method according to claim 5, wherein a plurality of first combs secured together so as to form a first single-piece unit are obtained during step a) and step a) comprises a splitting step a1) in which said first unit is split in order to deliver said plurality of first combs shaped in individual units separated from one another.

7. The manufacturing method according to any of claims 5 or 6, wherein the material used in the additive manufacturing method in step a) is the first material in which each first part (10) is made.

8. The manufacturing method according to any of claims 1 to 7, wherein step b) consists of an additive manufacturing method in which a material is deposited in successive passes on a tray, the result of the successive deposits during the different passes comprising a second comb whose shape corresponds to the shape of each second part (20).

9. The manufacturing method according to claim 8, wherein a plurality of second combs secured together so as to form a second single-piece unit are obtained during step b) and step b) comprises a splitting step b1) in which said second unit is split in order to deliver said plurality of second combs shaped in individual units separated from one another.

10. The manufacturing method according to any of claims 8 or 9, wherein the material used in the additive manufacturing method in step b) is the second material in which each second part (20) is made.

11. The manufacturing method according to any of claims 5 or 6 and according to any of claims 8 or 9, wherein the material used in the additive manufacturing method of step a) and the material used in the additive manufacturing method of step b) are identical, wherein step a) comprises a step of doping by implantation or by heat treatment in order to convert the material used in the additive manufacturing method of step a) into the first material in which the at least one first part (10) is made, and wherein step b) comprises a step of doping by implantation or by heat treatment in order to convert the material used in the additive manufacturing method of step b) into the second material in which the at least one second part (20) is made.

**Fig.1**

**Fig. 2**

**Fig. 3**

**Fig. 4**

**Fig. 5**

**Fig. 6**

**Fig. 7**

**Fig. 8**

**EP 3 985 745 B1**

## RÉFÉRENCES CITÉES DANS LA DESCRIPTION

**Documents brevets cités dans la description**

- US 2019131508 A1